# EUROPEAN PATENT APPLICATION

(11) **EP 4 848 946 A1**
(43) Date of publication of application: **02.12.2026**
(21) Application number: 25744891.0
(22) Date of filing: 15.01.2025
(51) Int. Cl.: H10F 19/90, H10F 10/00

(54) **SOLAR MODULE, SOLAR CELL, AND METHOD FOR MANUFACTURING SOLAR MODULE**

(30) Priority: 22.01.2024 JP 2024007672
(71) Applicant: PXP Corporation, Sagamihara-shi, Kanagawa 252-0203 (JP); SOLABLE Inc., Tokyo 100-7014 (JP)
(72) Inventor: SUGIMOTO, Hiroki, Sagamihara-shi, Kanagawa 252-0203 (JP); ARITA, Kazuo, Sagamihara-shi, Kanagawa 252-0203 (JP)
(74) Representative: EIP
(86) International application number: PCT/JP2025/000920
(87) International publication number: WO 2025/158961

(57) **Abstract**

An object of the present invention is to provide a solar module, a solar cell, and a method for manufacturing a solar module, all of which are for suppressing an increase in electrical resistance. The present disclosure relates to a solar module including: a first solar cell having at least a conductive corrosion-preventive layer, a first conductive substrate, a first power generating element layer, and a first electrode in this order; and a second solar cell having at least a second conductive substrate, a second power generating element layer, and a second electrode in this order, in which the conductive corrosion-preventive layer of the first solar cell and the second electrode of the second solar cell are bonded to each other with at least a conductive adhesive member interposed between the conductive corrosion-preventive layer and the second electrode.

## Description

### Technical Field

The present invention relates to a solar module, a solar cell, and a method for manufacturing a solar module.

### Background Art

In order to improve voltage characteristics and the like of a solar module, solar cells are electrically connected in series. In this case, examples of a method for bonding the solar cells to each other include a method of soldering a back-surface electrode of one solar cell to a metal ribbon, and a metal ribbon line to a front-surface electrode of the other solar cell, respectively. However, there is a problem in that a soldered bonding portion is weak against mechanical vibration or thermal shock. In addition, in a thin-film solar cell, there is a problem in that a thickness of the soldered bonding portion increases and a surface of the thin-film solar cell is uneven.

Patent Literature 1 discloses a method of bonding a solar cell and a busbar using a conductive adhesive member.

### Citation List

### Patent Literature

Patent Literature 1: Japanese Patent No. 3751539

### Summary of Invention

### Technical Problem

When a solar module is produced by bonding a back-surface electrode of one solar cell and a front-surface electrode of the other solar cell using a conductive adhesive member as in the method of Patent Literature 1, without using a metal ribbon line, the problem in bonding by soldering does not occur. In addition, in the bonding of the solar cells, the number of required members can be reduced, required processes can be simplified, and the cost can be reduced.

Meanwhile, it is known that the performance of a solar cell is improved by performing a heat treatment on the solar cell in an atmosphere such as a sulfur atmosphere. In the above-described bonding method using a conductive adhesive member, the back-surface electrode of one solar cell is exposed. Therefore, when the solar cell is subjected to the heat treatment in an atmosphere such as a sulfur atmosphere, the back-surface electrode is modified, and the performance as an electrode deteriorates. As a result, it is found that an electrical resistance increases in a bonding region between the solar cells, and an electrical resistance of the solar module increases.

An object of the present invention is to provide a solar module, a solar cell, and a method for manufacturing a solar module, all of which are for suppressing an increase in electrical resistance.

### Solution to Problem

A solar module according to one embodiment of the present invention includes a first solar cell having at least a conductive corrosion-preventive layer, a first conductive substrate, a first power generating element layer, and a first electrode in this order, and a second solar cell having at least a second conductive substrate, a second power generating element layer, and a second electrode in this order, in which the conductive corrosion-preventive layer of the first solar cell and the second electrode of the second solar cell are bonded to each other with at least a conductive adhesive member interposed between the conductive corrosion-preventive layer and the second electrode.

The present inventors have found that, in the solar module, when the conductive corrosion-preventive layer of the first solar cell and the second electrode of the second solar cell are bonded to each other with at least a conductive adhesive member interposed therebetween, an increase in electrical resistance in a bonding region between the solar cells can be suppressed.

A solar cell according to one embodiment of the present invention includes at least a conductive corrosion-preventive layer, a conductive substrate, a power generating element layer, and an electrode in this order.

The present inventors have found that, when the solar cell includes at least a conductive corrosion-preventive layer, a conductive substrate, a power generating element layer, and an electrode in this order, an increase in electrical resistance of the solar cell can be suppressed.

A method for manufacturing a solar cell according to one embodiment of the present invention includes a laminate preparation step of preparing a laminate having at least a conductive corrosion-preventive layer, a conductive substrate, and a precursor of a light-absorbing layer in this order, a heat treatment step of subjecting the laminate to heat treatment in one or more atmospheres selected from the group consisting of a sulfur atmosphere, a selenium atmosphere, a chlorine atmosphere, a bromine atmosphere, and an iodine atmosphere, a power generating element layer formation step of forming a power generating element layer having the light-absorbing layer formed by the heat treatment step, and an electrode formation step of forming an electrode on the power generating element layer.

The present inventors have found that, when the method for manufacturing a solar cell includes the laminate preparation step of preparing a laminate having at least a conductive corrosion-preventive layer, a conductive substrate, and a precursor of a light-absorbing layer in this order, an increase in electrical resistance of the solar cell manufactured by the manufacturing method can be suppressed. **Advantageous Effect of Invention**

According to the present invention, it is possible to provide a solar module that suppresses an increase in electrical resistance in a bonding region between solar cells, and a solar cell and a method for manufacturing a solar cell, each capable of suppressing an increase in electrical resistance.

### Brief Description of Drawings

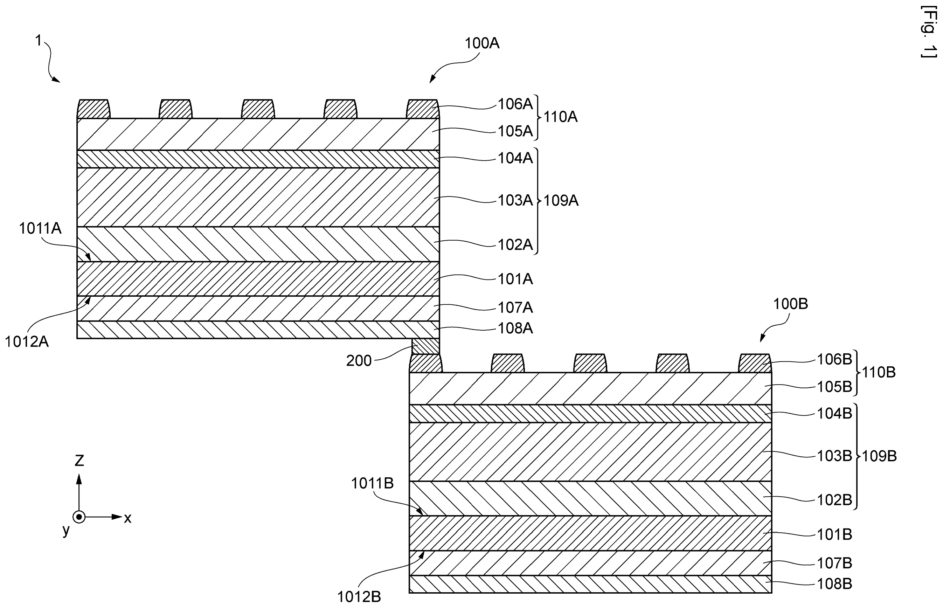

[Figure 1] Figure 1 is a schematic cross-sectional view of a solar module according to an embodiment of the present invention.

### Description of Embodiments

Hereinafter, embodiments (hereinafter, referred to as "the present embodiments") for carrying out the present invention will be described in detail with reference to drawings as necessary. However, the present invention is not limited thereto, and various modifications are possible without departing from the gist. In the drawings, the same elements will be represented by the same reference numerals, and redundant descriptions thereof will be omitted. In addition, the positional relationship such as up, down, left, and right is based on the positional relationship shown in the drawings unless otherwise specified. Furthermore, the dimensional ratios in the drawings are not limited to the ratios shown in the drawings.

### 1. Solar module

Figure 1 is a schematic cross-sectional view of a solar module according to an embodiment of the present invention. A solar module 1 according to the present embodiment includes a first solar cell 100A having at least a conductive corrosion-preventive layer 107A, a first conductive substrate 101A, a first power generating element layer 109A, and a first electrode 110A in this order, and a second solar cell 100B having at least a second conductive substrate 101B, a second power generating element layer 109B, and a second electrode 110B in this order, in which the conductive corrosion-preventive layer 107A of the first solar cell 100A and the second electrode 110B of the second solar cell 100B are bonded to each other with at least a conductive adhesive member 200 interposed therebetween.

In the present embodiment, when the first solar cell 100A and the second solar cell 100B are not distinguished from each other, they are also simply referred to as a solar cell 100. In addition, when the first solar cell 100A and the second solar cell 100B are not distinguished from each other, A or B may be omitted from the reference numerals for the respective layers. For example, when the first conductive substrate 101A and the second conductive substrate 101B are not distinguished from each other, they are also simply referred to as a conductive substrate 101.

The solar module 1 includes a plurality of solar cells 100, and for example, as shown in Figure 1, may include two solar cells 100 or may include three or more solar cells 100. The solar cell 100 has at least a conductive substrate 101, a power generating element layer 109, and an electrode 110 in this order. In addition, among the plurality of solar cells 100 in the solar module 1, one or more solar cells 100 have at least a conductive corrosion-preventive layer 107, a conductive substrate 101, a power generating element layer 109, and an electrode 110 in this order. In the solar module 1, the conductive corrosion-preventive layer 107 of a certain solar cell 100 and the electrode 110 of another solar cell 100 are bonded to each other with at least a conductive adhesive member interposed therebetween. In Figure 1, the conductive adhesive member 200 is disposed on one grid of a grid electrode 106 to bond the solar cells 100 to each other, but the conductive adhesive member 200 may be disposed on a region including a plurality of grids of the grid electrode 106 to bond the solar cells 100 to each other. In addition, when the electrode 110 includes only an electrode layer 105 and not the grid electrode 106, the conductive adhesive member 200 may be disposed on the electrode layer 105 to bond the solar cells 100 to each other.

The solar module 1 receives light from the electrode 110 side to generate power. Therefore, from the viewpoint of power generation efficiency, it is preferable that a bonding region between the solar cells 100 is as small as possible within a range in which bonding strength is ensured.

The solar module 1 can form a thin-film solar module or a thin-film flexible solar module by forming the solar cell 100 to be sufficiently thin.

Generally, in a solar cell constituting a solar module, after a precursor of a light-absorbing layer is formed on a conductive substrate, heat treatment is performed in an atmosphere such as selenium gas and sulfur gas to form a light-absorbing layer. When the solar cell 100 constituting the solar module 1 according to the present embodiment is manufactured, even when such a heat treatment is performed, it is possible to suppress an increase in electrical resistance of the conductive substrate 101. As a result, in the solar module 1, it is possible to suppress an increase in electrical resistance in a bonding region between the solar cells 100. Although the factor is not particularly limited, it is presumed as follows.

Regarding the first solar cell 100A, in the heat treatment of a laminate having at least the conductive corrosion-preventive layer 107A, the first conductive substrate 101A, and a precursor of the first light-absorbing layer 103A in this order, the first conductive substrate 101A and the conductive corrosion-preventive layer 107A on a second surface 1012A side of the first conductive substrate 101A are also subjected to the heat treatment together with the precursor of the first light-absorbing layer 103A. Here, in a region of the second surface 1012A of the first conductive substrate 101A where the conductive corrosion-preventive layer 107A is present, the second surface 1012A is not modified, and an increase in electrical resistance of the first conductive substrate 101A in the region is suppressed. In addition, an electrical resistance of the conductive corrosion-preventive layer 107A is less likely to increase even when subjected to the heat treatment. Here, in the solar module 1, the conductive corrosion-preventive layer 107A of the first solar cell 100A and the second electrode 110B of the second solar cell 100B are bonded to each other with at least the conductive adhesive member 200 interposed therebetween. That is, since the region of the first solar cell 100A, in which the electrical resistance is not increased, is bonded to the second electrode 110B of the second solar cell 100B, it is considered that, in the solar module 1, it is possible to suppress the increase in electrical resistance in the bonding region between the solar cells 100.

The region on a second surface 1012 of the conductive substrate 101, where the conductive corrosion-preventive layer 107 is present, is a region on a second surface 101b where the conductive corrosion-preventive layer 107 is present in a direction perpendicular to the second surface 1012. For example, when the conductive corrosion-preventive layer 107 is provided on the second surface 1012 of the conductive substrate 101, a region in contact with the conductive corrosion-preventive layer 107 on the second surface 1012 is the region on the second surface 1012 of the conductive substrate 101 where the conductive corrosion-preventive layer 107 is present.

In addition, since the conductive corrosion-preventive layer 107 has conductivity, the plurality of solar cells 100 can be electrically connected in series by directly bonding a front surface of the second solar cell 100B on a side where the second electrode 110B is present and a back surface of the first solar cell 100A on a side where the conductive corrosion-preventive layer 107A is present. That is, in the solar module 1 according to the present embodiment, the solar cells 100 can be simply electrically connected to each other in series without requiring soldering of a conductive wire such as a wire. In addition, compared with a solar module manufactured by soldering, cracks are less likely to occur in the bonding region between the solar cells 100 in the solar module 1 according to the present embodiment, so that the structure of the solar module 1 according to the present embodiment is less likely to collapse even when subjected to mechanical vibration or thermal shock.

Hereinafter, each configuration that can be included in the solar module 1 will be described in detail.

In the present embodiment, when a compound is expressed by name, not only the pure compound itself but also the compound to which a trace amount of an element or the like is added within a range in which characteristics of the compound are not lost is included.

In addition, in the present embodiment, since the element in each layer of the solar module can be present in different oxidation states, all the oxidation states are referred to by the name of the element unless otherwise specified. For example, "hydrogen element" means a hydrogen atom, a hydrogen ion, a hydride ion, hydrogen in the form of a compound, and hydrogen in an elemental state.

### 1.1. Solar cell

The solar module 1 according to the present embodiment is configured from the plurality of solar cells 100. The solar cell 100 includes at least a conductive substrate 101, a power generating element layer 109, and an electrode 110 in this order. In addition, among the plurality of solar cells 100 in the solar module 1, one or more solar cells 100 have at least a conductive corrosion-preventive layer 107, a conductive substrate 101, a power generating element layer 109, and an electrode 110 in this order. In addition, an intermediate layer may be provided between the respective layers as needed from the viewpoint of adhesion, bondability, conductivity, and the like between the layers.

The solar cell 100 may have, for example, a conductive substrate 101, a power generating element layer 109 provided on a first surface 1011 of the conductive substrate 101, an electrode 110 provided on the power generating element layer 109, and a conductive corrosion-preventive layer 107 provided on a second surface 1012 of the conductive substrate 101.

The solar cell 100 may have, for example, a conductive substrate 101, a power generating element layer 109 provided on the first surface 1011 of the conductive substrate 101, an electrode 110 provided on the power generating element layer 109, a conductive corrosion-preventive layer 107 provided on the second surface 1012 of the conductive substrate 101, and a contact-resistance-reducing layer 108 provided on a surface of the conductive corrosion-preventive layer 107 opposite to the conductive substrate 101.

The solar cell 100 may have, for example, the conductive substrate 101, a hole transport layer 102 provided on the first surface 1011 of the conductive substrate 101, a light-absorbing layer 103 provided on the hole transport layer 102, an electron transport layer 104 provided on the light-absorbing layer 103, the electrode 110 provided on the electron transport layer 104, the conductive corrosion-preventive layer 107 provided on the second surface 1012 of the conductive substrate 101, and the contact-resistance-reducing layer 108 provided on a surface of the conductive corrosion-preventive layer 107 opposite to the conductive substrate 101.

### 1.1.1. Conductive substrate

The solar cell 100 has the conductive substrate 101. The conductive substrate 101 is provided to extract, for example, a current caused by holes generated in the light-absorbing layer 103 described later. The conductive substrate 101 is not particularly limited as long as it has conductivity, but for example, a metal conductive layer made of a metal such as Ti and Al; a conductive inorganic compound conductive layer made of a conductive inorganic compound other than a metal; or a conductive organic compound conductive layer made of a conductive organic compound can be used. Among the above, a metal conductive layer made of Ti is preferable from the viewpoint of suppressing diffusion of impurities, suppressing a mismatch of coefficient of thermal expansion, and the like. In the conductive substrate 101, one kind of the above-described materials may be used alone, or two or more kinds thereof may be used in combination.

A thickness of the conductive substrate 101 is not particularly limited, but is, for example, 30 µm or more and 100 µm or less, or 30 µm or more and 60 µm or less. When the thickness of the conductive substrate 101 is within the above-described range, the solar cell tends to be lightened or flexible while the current can be sufficiently extracted without loss.

### 1.1.2. Power generating element layer

The solar cell 100 has the power generating element layer 109. The power generating element layer 109 absorbs light to generate holes and electrons, thereby generating a current. A thickness of the power generating element layer 109 is not particularly limited, but is, for example, 1 µm or more and 4 µm or less.

### 1.1.2.1. Hole transport layer

The power generating element layer 109 may have a hole transport layer 102. The hole transport layer 102 can, for example, efficiently extract holes generated in the light-absorbing layer 103 described later from the light-absorbing layer 103, and suppress recombination of the holes and electrons generated simultaneously with the holes in the light-absorbing layer 103 described later. The hole transport layer 102 is preferably a p-type semiconductor. A substance contained in the p-type semiconductor is not particularly limited, and examples thereof include an inorganic compound such as nickel oxide, molybdenum oxide, copper gallium oxide, copper aluminum oxide, molybdenum selenide, and molybdenum sulfoselenide. The p-type semiconductor may be used alone or in combination of two or more kinds thereof.

The hole transport layer 102 preferably consists essentially of the above-described p-type semiconductor, and is preferably the above-described p-type semiconductor. In addition, a content of the above-described p-type semiconductor in the hole transport layer 102 is preferably 80% by mass or more and 100% by mass or less, 90% by mass or more and 100% by mass or less, 95% by mass or more and 100% by mass or less, or 99% by mass or more and 100% by mass or less with respect to the total amount of the hole transport layer 102.

A thickness of the hole transport layer 102 is preferably 10 nm or more and 100 nm or less, 15 nm or more and 80 nm or less, or 20 nm or more and 60 nm or less. When the thickness of the hole transport layer 102 is within the above-described range, the solar cell tends to be lightened or flexible while holes generated in the light-absorbing layer 103 described later are efficiently extracted from the light-absorbing layer 103, and recombination of the holes and electrons generated simultaneously with the holes in the light-absorbing layer 103 described later is suppressed.

### 1.1.2.2. Light-absorbing layer

The power generating element layer 109 may have a light-absorbing layer 103. The light-absorbing layer 103 absorbs light such as near-infrared light, visible light, and ultraviolet light to generate electrons and holes, for example. Examples of the light such as near-infrared light, visible light, and ultraviolet light include sunlight. The light-absorbing layer 103 preferably contains a perovskite compound, a chalcopyrite compound, or a kesterite compound. The perovskite compound may be used alone or in combination of two or more kinds thereof. The chalcopyrite compound may be used alone or in combination of two or more kinds thereof. In addition, the kesterite compound may be used alone or in combination of two or more kinds thereof.

Examples of the perovskite compound include a compound represented by General Formula AMX₃ and a compound represented by General Formula A₂MX₄. Here, M represents a divalent cation, A represents a monovalent cation, and X represents a monovalent anion.

The monovalent cation A is not particularly limited, and examples thereof include a cation of an element of Group 1 in the periodic table and an organic cation. Among the above, a cesium ion, a rubidium ion, an ammonium ion (including an amidinium ion) which may have a substituent, a phosphonium ion which may have a substituent, or an amidinium ion which may have a substituent is preferable. Examples of the ammonium ion which may have a substituent include a primary ammonium ion and a secondary ammonium ion. Specific examples of the ammonium ion which may have a substituent include an alkylammonium ion, an arylammonium ion, an amidinium ion, and a guanidinium ion. In particular, in order to avoid steric hindrance, a monoalkylammonium ion is preferable, and from the viewpoint of improving stability, an alkylammonium ion substituted with one or more fluorine atoms is preferably used. In addition, a combination of two or more kinds of cations can also be used as the cation A. Examples of the monovalent cation A include a methylammonium ion, a monofluoromethylammonium ion, a difluoromethylammonium ion, a trifluoromethylammonium ion, an ethylammonium ion, an isopropylammonium ion, an n-propylammonium ion, an isobutylammonium ion, an n-butylammonium ion, a t-butylammonium ion, a dimethylammonium ion, a diethylammonium ion, a phenylammonium ion, a benzylammonium ion, a phenethylammonium ion, a guanidinium ion, a formamidinium ion, an acetamidinium ion, and an imidazolium ion.

The divalent cation M is not particularly limited, and examples thereof include a divalent metal cation and a metalloid cation. Specific examples thereof include a cation of an element of Group 14 in the periodic table, and more specific examples thereof include a lead cation (Pb²⁺), a tin cation (Sn²⁺), and a germanium cation (Ge²⁺). In addition, a combination of two or more kinds of cations can also be used as the cation M.

The monovalent anion X is not particularly limited, and examples thereof include a halide ion, an acetate ion, a nitrate ion, a sulfate ion, a borate ion, an acetylacetonate ion, a carbonate ion, a citrate ion, a sulfur ion, a tellurium ion, a thiocyanate ion, a titanate ion, a zirconate ion, a 2,4-pentanedionate ion, and a fluorosilicate ion. X may be one kind of anion or a combination of two or more kinds of anions. As X, a halide ion or a combination of a halide ion and another anion is preferably used. Examples of the halide ion X include a chloride ion, a bromide ion, and an iodide ion.

Examples of the perovskite compound include an organic-inorganic perovskite compound, and particularly, a halide-based organic-inorganic perovskite compound. Specific examples of the perovskite compound include CH₃NH₃PbI₃, CH₃NH₃PbBr₃, CH₃NH₃PbCl₃, CH₃NH₃SnI₃, CH₃NH₃SnBr₃, CH₃NH₃SnCl₃, CH₃NH₃PbI₍₃₋ₓ₎Clₓ, CH₃NH₃PbI₍₃₋ₓ₎Brₓ, CH₃NH₃PbBr₍₃₋ₓ₎Clₓ, CH₃NH₃Pb_{(1-y)}Sn_{y}I₃, CH₃NH₃Pb_{(1-y)}Sn_{y}Br₃, CH3NH3Pb(1-y)SnyCl3, CH3NH3Pb(1-y)SnyI(3-x)Clx, CH3NH3Pb(1-y)SnyI(3-x)Brx, CH₃NH₃Pb_{(1-y)}Sn_{y}Br₍₃₋ₓ₎Clₓ, and compounds in which CFH₂NH₃, CF₂HNH₃, CF₃NH₃, or NH₂CH=NH₂ is used instead of CH₃NH₃ in the compounds. In the above-described formulae, x represents an arbitrary value of 0 or more and 3 or less, and y represents an arbitrary value of 0 or more and 1 or less.

Preferred examples of the chalcopyrite compound include an I-III-VI₂ group chalcopyrite compound. The I-III-VI₂ group chalcopyrite compound is not particularly limited, and examples thereof include CuAlS₂, CuAlSe₂, CuAlTe₂, CuGaS₂, CuGaSe₂, CuGaTe₂, CuInS₂, CuInSe₂, CuInTe₂, AgAlS₂, AgAlSe₂, AgAlTe₂, AgGaS₂, AgGaSe₂, AgGaTe₂, AgInS₂, AgInSe₂, AgInTe₂, and combinations thereof. The "combinations thereof" is not particularly limited, and examples thereof include Cu(InₓGa₁₋ₓ)(Se_{y}S_{1-y})₂ (0 ≤ x ≤ 1, 0 ≤ y ≤ 1) when CuGaS₂ and CuInSe₂ are combined. Among these chalcopyrite compounds, CuGaS₂, CuGaSe₂, CuInS₂, CuInSe₂, or Cu(InₓGa₁₋ₓ)(Se_{y}S_{1-y})₂ (0 ≤ x ≤ 1, 0 ≤ y ≤ 1) is preferable, and Cu(InₓGa₁₋ₓ)(Se_{y}S_{1-y})₂ (0 ≤ x ≤ 1, 0 ≤ y ≤ 1) is more preferable. In the present embodiment, a CIS compound is a chalcopyrite compound including Cu, In, and Se, a CIGS compound is a chalcopyrite compound including Cu, In, Ga, and Se, and a CIGSS compound is a chalcopyrite compound including Cu, In, Ga, Se, and S.

Preferred examples of the kesterite compound include an I₂-II-IV-VI₄ group kesterite compound. The I₂-II-IV-VI₄ group kesterite compound is not particularly limited, and examples thereof include Cu₂ZnSnS₄, Cu₂ZnSnSe₄, Cu₂ZnGeS₄, Cu₂ZnGeSe₄, Cu₂MnSnS₄, Cu₂MnSnSe₄, Cu₂MnGeS₄, Cu₂MnGeSe₄, Ag₂ZnSnS₄, Ag₂ZnSnSe₄, Ag₂ZnGeS₄, Ag₂ZnGeSe₄, Ag₂MnSnS₄, Ag₂MnSnSe₄, Ag₂MnGeS₄, Ag₂MnGeSe₄, and combinations thereof. The "combinations thereof" are not particularly limited, and include, for example, (CuₓAg₁₋ₓ)₂ZnSn(S_{y}Se_{1-y})₄ (0 ≤ x ≤1) when Cu₂ZnSnS₄ and Ag₂ZnSnSe₄ are combined. Examples thereof also include Cu₂ZnSn(SₓSe₁₋ₓ)₄ (0 ≤ x ≤ 1, 0 ≤ y ≤ 1). Among these kesterite compounds, Cu₂ZnSnS₄, Cu₂ZnSnSe₄, Ag₂ZnSnS₄, Ag₂ZnSnSe₄, or (CuₓAg₁₋ₓ)₂ZnSn(S_{y}Se_{1-y})₄ (0 ≤ x ≤ 1, 0 ≤ y ≤ 1) is preferable, and (CuₓAg₁₋ₓ)₂ZnSn(S_{y}Se_{1-y})₄ (0 ≤ x ≤ 1, 0 ≤ y ≤ 1) is more preferable. In the present embodiment, a CZTS compound is a kesterite compound including Cu, Zn, Sn, and S, an ACZTS compound is a kesterite compound including Ag, Cu, Zn, Sn, and S, and an ACZTSS compound is a kesterite compound including Ag, Cu, Zn, Sn, S, and Se.

A content of the perovskite compound, the chalcopyrite compound, and the kesterite compound in the light-absorbing layer 103 is not particularly limited as long as the light-absorbing layer 103 can absorb light such as visible light and ultraviolet light to generate electrons and holes. More specifically, although not particularly limited, the content of the perovskite compound, the chalcopyrite compound, and the kesterite compound is 50% by mass or more and 100% by mass or less, 60% by mass or more and 100% by mass or less, 70% by mass or more and 100% by mass or less, 80% by mass or more and 100% by mass or less, or 90% by mass or more and 100% by mass or less with respect to the total mass of the light-absorbing layer 103.

The light-absorbing layer 103 may contain an additive such as a binder and a surfactant, in addition to the above-described material. A content of the above-described additive is not particularly limited, but is, for example, 0.1% by mass or more and 10% by mass or less with respect to the total mass of the light-absorbing layer 103. The light-absorbing layer 103 may not contain the above-described additive.

A thickness of the light-absorbing layer 103 is preferably 0.5 µm or more and 10.0 µm or less, 0.5 µm or more and 7.5 µm or less, 0.5 µm or more and 5.0 µm or less, or 0.5 µm or more and 3.0 µm or less. When the thickness of the light-absorbing layer 103 is within the above-described range, the solar cell tends to be lightened or flexible while light such as visible light and ultraviolet light can be absorbed to generate electrons and holes.

The solar cell 100 according to the present embodiment may have two light-absorbing layers 103. In this case, a substance contained in the first light-absorbing layer 103 and a substance contained in the second light-absorbing layer 103 may be different from or the same as each other, but are preferably different from each other. When the solar cell 100 has two light-absorbing layers 103, a wavelength region of light that can be absorbed by the light-absorbing layers 103 tends to be expanded, and as a result, performance of the solar cell tends to be improved. In addition, the solar cell 100 according to the present embodiment may have three or more light-absorbing layers 103.

A precursor of the light-absorbing layer 103 formed on the first surface 1011 side of the conductive substrate 101 is subjected to a heat treatment in an atmosphere such as a sulfur atmosphere, a selenium atmosphere, a chlorine atmosphere, a bromine atmosphere, and an iodine atmosphere, whereby the light-absorbing layer 103 is formed. In particular, when the light-absorbing layer 103 contains the perovskite compound, the chalcopyrite compound, or the kesterite compound, it is preferable that the precursor of the light-absorbing layer 103 is formed on the first surface 1011 side or the first surface 1011 of the conductive substrate 101, and then subjected to the heat treatment in the above-described atmosphere. Even when such a heat treatment is performed when manufacturing the solar cell 100 constituting the solar module 1 according to the present embodiment, it is possible to suppress the increase in electrical resistance of the conductive substrate 101; and as a result, in the solar module 1, it is possible to suppress the increase in electrical resistance in the bonding region between the solar cells 100.

The precursor of the light-absorbing layer 103 is not particularly limited, and examples thereof include the following substances.

When the light-absorbing layer 103 contains the perovskite compound, examples thereof include a laminate of PbI₂, FAI, or the like. When the light-absorbing layer 103 contains the chalcopyrite compound, examples thereof include a laminate of CuGa, In, or the like. When the light-absorbing layer 103 contains the kesterite compound, examples thereof include a laminate of Zn, Sn, Cu, or the like.

### 1.1.2.3. Electron transport layer

The power generating element layer 109 may have an electron transport layer 104. The electron transport layer 104 can efficiently extract electrons generated in the light-absorbing layer 103 from the light-absorbing layer 103, and suppress recombination of the electrons and holes generated simultaneously with the electrons in the light-absorbing layer 103. The electron transport layer 104 is preferably an n-type semiconductor. A substance contained in the n-type semiconductor is not particularly limited, and examples thereof include zinc oxide, tin oxide, titanium oxide, zinc oxysulfide (zinc oxide to which an elemental sulfur is added), magnesium zinc oxide (zinc oxide to which an elemental magnesium is added), tin zinc oxide (zinc oxide to which an elemental tin is added), and titanium zinc oxide (zinc oxide to which an elemental titanium is added). The n-type oxide semiconductor may be used alone or in combination of two or more kinds thereof.

The electron transport layer 104 that is the n-type oxide semiconductor preferably consists essentially of zinc oxide, tin oxide, titanium oxide, zinc oxysulfide, magnesium zinc oxide, tin zinc oxide, or titanium zinc oxide, and is preferably zinc oxide, tin oxide, titanium oxide, zinc oxysulfide, magnesium zinc oxide, tin zinc oxide, or titanium zinc oxide. In addition, a content of the zinc oxide, tin oxide, titanium oxide, zinc oxysulfide, magnesium zinc oxide, tin zinc oxide, or titanium zinc oxide in the electron transport layer 104 that is the n-type oxide semiconductor is preferably 80% by mass or more and 100% by mass or less, 90% by mass or more and 100% by mass or less, 95% by mass or more and 100% by mass or less, or 99% by mass or more and 100% by mass or less with respect to the total amount of the electron transport layer 104.

A thickness of the electron transport layer 104 is preferably 50 nm or more and 200 nm or less, 55 nm or more and 175 nm or less, 60 nm or more and 150 nm or less, or 65 nm or more and 125 nm or less. When the thickness of the electron transport layer 104 is within the above-described range, the solar cell tends to be lightened or flexible while electrons generated in the light-absorbing layer 103 are efficiently extracted from the light-absorbing layer 103, and recombination of the electrons and holes generated simultaneously with the electrons in the light-absorbing layer 103 is suppressed.

### 1.1.3. Electrode

The solar cell 100 has the electrode 110. The electrode 110 is provided, for example, to extract a current caused by the electrons generated in the light-absorbing layer 103.

### 1.1.3.1. Electrode layer

The electrode 110 may have an electrode layer 105. In addition, in the solar cell 100, since the light-absorbing layer 103 absorbs light passing through the electrode layer 105, the electrode layer 105 is preferably a transparent electrode layer in order to increase the amount of light absorbed by the light-absorbing layer 103. The transparent electrode is an electrode using a material having both high electrical conductivity and high visible light transmittance. The high electrical conductivity is not particularly limited, but means, for example, that a resistivity is 5.0 × 10⁻³ Ωcm or less. The high visible light transmittance is not particularly limited, but means, for example, that an average transmittance in a wavelength region of 400 nm or more and 1300 nm or less is 80% or more. As a material for the transparent electrode, a known material can be used, and examples thereof include indium tin oxide (ITO), hydrogen-containing indium oxide (IOH), fluorine-containing tin oxide (FTO), boron-containing zinc oxide (ZnO:B), and aluminum-containing zinc oxide (ZnO:Al).

When the electrode layer 105 is a transparent electrode, a content of the above-described material is not particularly limited as long as the electrode layer 105 functions as a transparent electrode. More specifically, although not particularly limited, the content of the above-described material is 50% by mass or more and 100% by mass or less, 60% by mass or more and 100% by mass or less, 70% by mass or more and 100% by mass or less, 80% by mass or more and 100% by mass or less, 90% by mass or more and 100% by mass or less, or 95% by mass or more and 100% by mass or less with respect to the total mass of the electrode layer 105.

A thickness of the electrode layer 105 is not particularly limited, and is, for example, 100 nm or more and 1,500 nm or less, or 200 nm or more and 1,000 nm or less. When the thickness of the electrode layer 105 is within the above-described range, the solar cell tends to be lightened or flexible while the current can be sufficiently extracted without loss.

### 1.1.3.2. Grid electrode

The electrode 110 may have a grid electrode 106. A material for the grid electrode 106 is not particularly limited as long as it has conductivity, and for example, a metal such as Mo, Cr, Ag, Cu, Ni, Al, and Ti; a conductive inorganic compound other than the metal; or a conductive organic compound can be used. The material for the grid electrode 106 may be used alone or in combination of two or more kinds thereof.

A content of the above-described material in the grid electrode 106 is not particularly limited as long as the grid electrode 106 functions as an electrode. More specifically, the content of the above-described material is not particularly limited, and is 50% by mass or more and 100% by mass or less, 60% by mass or more and 100% by mass or less, 70% by mass or more and 100% by mass or less, 80% by mass or more and 100% by mass or less, 90% by mass or more and 100% by mass or less with respect to the total mass of the grid electrode 106.

A thickness of the grid electrode 106 is not particularly limited, and is, for example, 5 µm or more and 50 µm or less. When the thickness of the grid electrode 106 is within the above-described range, the solar cell tends to be lightened or flexible while the current can be sufficiently extracted without loss.

The electrode 110 may include only the electrode layer 105, may include only the grid electrode 106, or may include the electrode layer 105 and the grid electrode 106. It is preferable that the electrode 110 includes the electrode layer 105 and the grid electrode 106.

### 1.1.4. Conductive corrosion-preventive layer

At least one of the solar cells 100 constituting the solar module 1 has the conductive corrosion-preventive layer 107. The conductive corrosion-preventive layer 107 is provided on the second surface 1012 side or on the second surface 1012 of the conductive substrate 101. In the heat treatment of the laminate having at least the conductive corrosion-preventive layer 107, the conductive substrate 101, and the precursor of the light-absorbing layer 103 in this order, the conductive substrate 101 and the conductive corrosion-preventive layer 107 provided on the second surface 1012 side of the conductive substrate 101 are also subjected to the heat treatment together with the precursor of the light-absorbing layer 103. Here, in the region on the second surface 1012 where the conductive corrosion-preventive layer 107 is present, the increase in electrical resistance of the conductive substrate 101 is suppressed. In addition, an electrical resistance of the conductive corrosion-preventive layer 107 is less likely to increase even when subjected to the heat treatment.

The conductive corrosion-preventive layer 107 may be provided on at least a part of a region on a surface of the conductive substrate 101 on the second surface 1012 side or on at least a part of a region on the second surface 1012, and may be provided on the entire surface of the conductive substrate 101 on the second surface 1012 side or on the entire second surface 1012.

The conductive corrosion-preventive layer 107 is subjected to a heat treatment together with the precursor of the light-absorbing layer 103. The heat treatment of the precursor of the light-absorbing layer 103 is performed at a high temperature (for example, 500°C) in a corrosive gas atmosphere such as a sulfur atmosphere, a selenium atmosphere, a chlorine atmosphere, a bromine atmosphere, and an iodine atmosphere. The conductive corrosion-preventive layer 107 subjected to the heat treatment in such an environment is modified at least partially on a surface on a side facing the conductive adhesive member 200 described later. For example, the conductive corrosion-preventive layer 107 subjected to the heat treatment at a high temperature (for example, 500°C) in a sulfur atmosphere, a selenium atmosphere, a chlorine atmosphere, a bromine atmosphere, or an iodine atmosphere is sulfurized, selenized, chlorinated, brominated, or iodinated at least partially on the surface on the side facing the conductive adhesive member 200 described later. The conductive corrosion-preventive layer 107 tends to be less likely to have an increased electrical resistance even when at least a part of the surface on the side facing the conductive adhesive member 200 described later is modified. Therefore, in the solar module 1, the electrical resistance in the bonding region between the solar cells 100 tends to be low.

In the solar module 1, the conductive corrosion-preventive layer 107 of the solar cell 100 may be bonded to the electrode 110 of another solar cell 100 through a conductive adhesive member.

The conductive corrosion-preventive layer 107 preferably contains metallic molybdenum or a molybdenum alloy. The molybdenum alloy preferably contains one or more elements selected from the group consisting of nickel, niobium, chromium, tungsten, silicon, and carbon. Among the above, a molybdenum alloy containing nickel is preferable, and a nickel-molybdenum alloy is more preferable. The metallic molybdenum or the molybdenum alloy may be used alone or in combination of two or more kinds thereof.

A content of nickel with respect to a content of molybdenum in the nickel-molybdenum alloy is preferably 10% by mass or more and 100% by mass or less, 15% by mass or more and 85% by mass or less, 20% by mass or more and 70% by mass or less, or 25% by mass or more and 55% by mass or less.

Examples of a method for adjusting the content of nickel with respect to the content of molybdenum in the nickel-molybdenum alloy include a method of adjusting amounts of metallic molybdenum and metallic nickel to be used when manufacturing the alloy.

The conductive corrosion-preventive layer 107 preferably consists essentially of metallic molybdenum or a molybdenum alloy, and is preferably metallic molybdenum or a molybdenum alloy. In addition, a content of the metallic molybdenum or the molybdenum alloy in the conductive corrosion-preventive layer 107 is preferably 80% by mass or more and 100% by mass or less, 90% by mass or more and 100% by mass or less, 95% by mass or more and 100% by mass or less, or 99% by mass or more and 100% by mass or less with respect to the total amount of the hole transport layer 102.

A thickness of the conductive corrosion-preventive layer 107 is preferably 50 nm or more and 350 nm or less, 75 nm or more and 325 nm or less, 100 nm or more and 300 nm or less, 125 nm or more and 275 nm or less, or 150 nm or more and 250 nm or less.

As described above, in manufacturing the solar cell 100 according to the present embodiment, the conductive corrosion-preventive layer 107 is subjected to the heat treatment together with the precursor of the light-absorbing layer 103 and the conductive substrate 101. Therefore, in order to prevent warpage from occurring in the solar cell 100 after the heat treatment, it is preferable that a difference in coefficient of thermal expansion between the conductive substrate 101 and the conductive corrosion-preventive layer 107 at a high temperature is small. From this viewpoint, the difference in coefficient of thermal expansion between the conductive substrate 101 and the conductive corrosion-preventive layer 107 at 500°C is preferably 5.0 × 10⁻⁶/°C or less, 0/°C or more and 5.0 × 10⁻⁶/°C or less, 0/°C or more and 4.5 × 10⁻⁶/°C or less, 0/°C or more and 4.0 × 10⁻⁶/°C or less, 0/°C or more and 3.5 × 10⁻⁶/°C or less, 0/°C or more and 3.0 × 10⁻⁶/°C or less, or 0/°C or more and 2.5 × 10⁻⁶/°C or less.

In addition, in order to prevent warpage from occurring in the solar cell 100, it is preferable that a difference in coefficient of thermal expansion between the conductive substrate 101 and the conductive corrosion-preventive layer 107 at each temperature is small. From this viewpoint, the difference in coefficient of thermal expansion between the conductive substrate 101 and the conductive corrosion-preventive layer 107 at 200°C is preferably 4.0 × 10⁻⁶/°C or less, 0/°C or more and 4.0 × 10⁻⁶/°C or less, 0/°C or more and 3.5 × 10⁻⁶/°C or less, 0/°C or more and 3.0 × 10⁻⁶/°C or less, 0/°C or more and 2.5 × 10⁻⁶/°C or less, or 0/°C or more and 2.0 × 10⁻⁶/°C or less.

In addition, a difference in coefficient of thermal expansion between the conductive substrate 101 and the conductive corrosion-preventive layer 107 at 20°C is preferably 3.5 × 10⁻⁶/°C or less, 0/°C or more and 3.5 × 10⁻⁶/°C or less, 0/°C or more and 3.0 × 10⁻⁶/°C or less, 0/°C or more and 2.5 × 10⁻⁶/°C or less, 0/°C or more and 2.0 × 10⁻⁶/°C or less, or 0/°C or more and 1.5 × 10⁻⁶/°C or less.

The coefficients of thermal expansion of the conductive substrate 101 and the conductive corrosion-preventive layer 107 are not particularly limited, but can be adjusted, for example, by changing the materials constituting the conductive substrate 101 and the conductive corrosion-preventive layer 107.

The coefficient of thermal expansion can be measured according to JIS Z 2285:2003, in which the temperature is set to 20°C, 200°C, or 500°C.

### 1.1.5. Contact-resistance-reducing layer

The solar cell 100 may have the contact-resistance-reducing layer 108. In the solar module 1, when the first solar cell 100A has a contact-resistance-reducing layer 108A, the contact-resistance-reducing layer 108A is provided between the conductive corrosion-preventive layer 107A and a conductive adhesive member 200 described later. The contact-resistance-reducing layer 108 tends to be able to further suppress the increase in electrical resistance in the bonding region between the solar cells 100 in the solar module 1.

The factor capable of suppressing the increase in electrical resistance in the bonding region between the solar cells 100 by providing the contact-resistance-reducing layer 108 is not particularly limited, but is considered as follows, for example. This is considered to be because, in addition to having low electrical resistance, the contact-resistance-reducing layer 108 tends to bond to both the conductive corrosion-preventive layer 107 and the conductive adhesive member 200 with low contact resistance.

Alternatively, the solar cell 100 may have the contact-resistance-reducing layer 108 on the side of the conductive corrosion-preventive layer 107 opposite to the conductive substrate 101.

The contact-resistance-reducing layer 108 is preferably provided on a surface of the conductive corrosion-preventive layer 107 on the side facing the conductive adhesive member 200, at least a part of which is modified. In addition, the contact-resistance-reducing layer 108 may be provided on the entire surface of the conductive corrosion-preventive layer 107 opposite to the conductive substrate 101, or may be provided in a partial region on the surface opposite to the conductive substrate 101.

A material for the contact-resistance-reducing layer 108 is not particularly limited as long as it has conductivity, and for example, a metal containing Ag, Sn, Cr, Cu, Ni, or the like can be used. The contact-resistance-reducing layer 108 preferably contains one or more selected from the group consisting of metallic silver, metallic tin, a silver alloy, and a tin alloy. Specific examples of the silver alloy and the tin alloy include a tin-zinc alloy, a tin-silver alloy, a tin-silver-copper alloy, and a tin-bismuth alloy. The material for the grid electrode 106 may be used alone or in combination of two or more kinds thereof.

A content of the above-described material in the contact-resistance-reducing layer 108 is not particularly limited, but is, for example, 50% by mass or more and 100% by mass or less, 60% by mass or more and 100% by mass or less, 70% by mass or more and 100% by mass or less, 80% by mass or more and 100% by mass or less, or 90% by mass or more and 100% by mass or less with respect to the total mass of the grid electrode 106.

A thickness of the contact-resistance-reducing layer 108 is preferably 25 nm or more and 125 nm or less, or 50 nm or more and 100 nm or less.

In the solar module 1, the contact-resistance-reducing layer 108 of the solar cell 100 may be bonded to the electrode 110 of another solar cell 100 through a conductive adhesive member.

### 1.2. Conductive adhesive member

The solar module 1 includes the conductive adhesive member 200. The conductive adhesive member 200 is provided to bond the solar cells 100 to each other and to establish electrical continuity between the solar cells 100.

Examples of the conductive adhesive member 200 include a conductive paste and a conductive sheet, and a conductive sheet is preferable from the viewpoint of more simply and firmly bonding the solar cells 100 to each other. The conductive sheet preferably contains a conductive mesh fabric having a metal coating film. Specifically, the conductive sheet preferably has a conductive mesh fabric having a metal coating film and a non-conductive adhesive present in an opening region of the mesh. Examples of such a conductive sheet include conductive double-sided tape MST50 (product name) or MST30 (product name) manufactured by SEIREN Co., Ltd.

When a conductive mesh fabric having a metal coating film is used as the conductive adhesive member 200, the electrical resistance in the bonding region between the solar cells 100 tends to be further reduced.

A thickness of the conductive adhesive member 200 is not particularly limited, but is, for example, 10 µm or more and 100 µm or less, 15 µm or more and 75 µm or less, or 20 µm or more and 50 µm or less.

### 2. Method for manufacturing solar cell

A method for manufacturing the solar cell 100 according to the present embodiment includes a laminate preparation step of preparing a laminate having at least the conductive corrosion-preventive layer 107, the conductive substrate 101, and the precursor of the light-absorbing layer 103 in this order, a heat treatment step of subjecting the laminate to heat treatment in one or more atmospheres selected from the group consisting of a sulfur atmosphere, a selenium atmosphere, a chlorine atmosphere, a bromine atmosphere, and an iodine atmosphere, a power generating element layer formation step of forming the power generating element layer 109 having the light-absorbing layer 103 formed by the heat treatment step, and an electrode formation step of forming the electrode 110 on the power generating element layer 109.

In the solar cell 100 manufactured by the manufacturing method according to the present embodiment, since the laminate having at least the conductive corrosion-preventive layer 107, the conductive substrate 101, and the precursor of the light-absorbing layer 103 in this order is heat-treated in one or more atmospheres selected from the group consisting of a sulfur atmosphere, a selenium atmosphere, a chlorine atmosphere, a bromine atmosphere, and an iodine atmosphere, a region of the second surface 1012 of the conductive substrate 101 where the conductive corrosion-preventive layer 107 is present is not modified, and an electrical resistance of the conductive substrate 101 does not increase in the region.

Hereinafter, each step that can be included in the method for manufacturing the solar cell 100 according to the present embodiment will be described in detail.

### 2.1. Laminate preparation step

In the laminate preparation step, the laminate having at least the conductive corrosion-preventive layer 107, the conductive substrate 101, and the precursor of the light-absorbing layer 103 in this order is prepared. Examples of a method for preparing such a laminate include a sputtering method.

Specifically, the precursor of the light-absorbing layer 103 may be laminated on the first surface 1011 of the conductive substrate 101 by a sputtering method, and then the conductive corrosion-preventive layer 107 may be laminated on the second surface 1012 of the conductive substrate 101 by a sputtering method.

The sputtering method may be performed in an argon atmosphere using a material for each layer as a sputtering target. For example, when the conductive corrosion-preventive layer 107 is formed on the second surface 1012 by a sputtering method, the sputtering method may be performed in an argon atmosphere using metallic molybdenum or a molybdenum alloy as a sputtering target.

### 2.2. Heat treatment step

In the heat treatment step, the laminate prepared in the laminate preparation step is subjected to heat treatment in one or more atmospheres selected from the group consisting of a sulfur atmosphere, a selenium atmosphere, a chlorine atmosphere, a bromine atmosphere, and an iodine atmosphere. By heat-treating the laminate in this manner, the light-absorbing layer 103 is formed on the first surface 1011 side of the conductive substrate 101.

In addition, the laminate includes the conductive corrosion-preventive layer 107 on the second surface 1012 side of the conductive substrate 101. Therefore, when the laminate is subjected to the above-described heat treatment, an increase in electrical resistance of the conductive substrate 101 can be suppressed in a region on the second surface 1012 where the conductive corrosion-preventive layer 107 is present. In addition, an electrical resistance of the conductive corrosion-preventive layer 107 is less likely to increase even when subjected to the heat treatment. As a result, an increase in electrical resistance of the solar cell 100 manufactured using the laminate can be suppressed.

The atmosphere when the heat treatment step is performed is one or more atmospheres selected from the group consisting of a sulfur atmosphere, a selenium atmosphere, a chlorine atmosphere, a bromine atmosphere, and an iodine atmosphere. Specifically, the atmosphere may be an atmosphere containing one kind selected from the group consisting of a sulfur atmosphere, a selenium atmosphere, a chlorine atmosphere, a bromine atmosphere, and an iodine atmosphere, or may be a mixed atmosphere containing two or more kinds selected from the group consisting of the above-described atmospheres. In addition, after the heat treatment step is performed in a certain atmosphere, the heat treatment step may be further performed in another atmosphere. Specifically, after the heat treatment step is performed in a selenium atmosphere, the heat treatment step may be performed in a sulfur atmosphere.

When the light-absorbing layer 103 is the chalcopyrite compound or the kesterite compound, the heat treatment step is preferably performed in any one or more atmospheres of a sulfur atmosphere and a selenium atmosphere, and it is more preferable that the heat treatment step is performed in a sulfur atmosphere after the heat treatment step is performed in a selenium atmosphere.

When the light-absorbing layer 103 is the perovskite compound, the heat treatment step is preferably performed in one or more atmospheres selected from the group consisting of a chlorine atmosphere, a bromine atmosphere, and an iodine atmosphere.

In the present embodiment, the sulfur atmosphere means an atmosphere containing a gas containing a sulfur element. That is, an atmosphere containing another gas having no sulfur element and a gas having a sulfur element falls within the sulfur atmosphere. The same applies to the selenium atmosphere, the chlorine atmosphere, the bromine atmosphere, and the iodine atmosphere.

In the heat treatment step, with regard to the sulfur atmosphere and the selenium atmosphere, a temperature of the heat treatment is preferably 300°C or higher and 700°C or lower, 350°C or higher and 650°C or lower, 400°C or higher and 600°C or lower, or 500°C or higher and 600°C or lower. With regard to the chlorine atmosphere, the bromine atmosphere, and the iodine atmosphere, a temperature of the heat treatment is preferably 60°C or higher and 230°C or lower, 70°C or higher and 200°C or lower, or 80°C or higher and 170°C or lower.

In the heat treatment step, a time for the heat treatment is preferably 1 minute or longer and 30 minutes or shorter, 3 minutes or longer and 15 minutes or shorter, or 5 minutes or longer and 15 minutes or shorter.

### 2.3. Power generating element layer formation step

In the power generating element layer formation step, the power generating element layer 109 is formed on the first surface 1011 of the conductive substrate 101. When the power generating element layer 109 consists of only the light-absorbing layer 103, as the heat treatment step is performed and the light-absorbing layer 103 is thus formed, the power generating element layer formation step is also performed. When the power generating element layer 109 has the light-absorbing layer 103 and a layer other than the light-absorbing layer 103, in the power generating element layer formation step, for example, a layer constituting the power generating element layer 109 other than the light-absorbing layer 103 is formed on the light-absorbing layer 103 formed by the heat treatment step. More specifically, for example, in the power generating element layer formation step, the electron transport layer 104 is formed on the light-absorbing layer 103 formed by the heat treatment step.

Examples of a method for forming each layer in the power generating element layer formation step include a sputtering method. The sputtering method may be performed in an argon atmosphere using a material for each layer as a sputtering target. For example, when the electron transport layer 104 is formed on the light-absorbing layer 103 by a sputtering method, the sputtering method may be performed in an argon atmosphere using zinc oxide and titanium oxide as sputtering targets to form an electron transport layer which is an n-type oxide semiconductor containing titanium zinc oxide.

### 2.4. Electrode formation step

In the electrode formation step, the electrode 110 is formed on the power generating element layer 109. Specifically, the electrode 110 is formed on a side of the power generating element layer 109 opposite to the conductive substrate 101, or on a surface opposite to the conductive substrate 101. Examples of a method for forming the electrode 110 include a sputtering method.

Specifically, the electrode layer 105 may be laminated on the power generating element layer 109 by a sputtering method, and then the grid electrode 106 may be provided on the electrode layer 105 by a sputtering method. The sputtering method may be performed in an argon atmosphere using a material for each configuration as a sputtering target.

Alternatively, a method of combining the sputtering method with another method may be used. Specifically, the electrode layer 105 may be laminated on the power generating element layer 109 by a sputtering method, and then the grid electrode 106 may be provided on the electrode layer 105 by a vapor deposition method, a method of printing a paste-like conductive material, or a method of pressure-bonding a conductive wire.

### 2.5. Contact-resistance-reducing layer formation step

The method for manufacturing a solar cell according to the present embodiment may include a contact-resistance-reducing layer formation step. The contact-resistance-reducing layer formation step is performed after the heat treatment step. In the contact-resistance-reducing layer formation step, the contact-resistance-reducing layer 108 is formed on the conductive corrosion-preventive layer 107. Examples of a method for forming the contact-resistance-reducing layer 108 include a sputtering method, a plating method, a vapor deposition method, and an ultrasonic soldering method. The sputtering method may be performed in an argon atmosphere using a material for each configuration as a sputtering target.

The contact-resistance-reducing layer 108 may be provided on the entire surface of the conductive corrosion-preventive layer 107 opposite to the conductive substrate 101, or may be provided in a partial region on the surface opposite to the conductive substrate 101.

### 3. Method for manufacturing solar module

A method for manufacturing the solar module 1 according to the present embodiment includes a bonding step of obtaining a first solar cell 100A and a second solar cell 100B, and bonding the conductive corrosion-preventive layer 107A of the first solar cell 100A and the second electrode 110B of the second solar cell 100B with at least a conductive adhesive member 200 interposed therebetween.

In the solar module 1 manufactured by the manufacturing method according to the present embodiment, the conductive corrosion-preventive layer 107A of the first solar cell 100A and the second electrode 110B of the second solar cell 100B are bonded to each other with at least the conductive adhesive member 200 interposed therebetween. Accordingly, in the solar module 1, it is possible to suppress an increase in electrical resistance in a bonding region between the solar cells 100.

Hereinafter, each step that can be included in the method for manufacturing the solar module 1 according to the present embodiment will be described in detail.

### 3.1. Bonding step

In the bonding step, the conductive corrosion-preventive layer 107A of the first solar cell 100A and the second electrode 110B of the second solar cell 100B are bonded to each other with at least the conductive adhesive member 200 interposed therebetween. In the bonding step, the conductive corrosion-preventive layer 107A of the first solar cell 100A and the second electrode 110B of the second solar cell 100B may be bonded to each other with only the conductive adhesive member 200 interposed therebetween, or may be bonded to each other with the contact-resistance-reducing layer 108A and the conductive adhesive member 200 interposed therebetween. That is, in the bonding step, the conductive corrosion-preventive layer 107A of the first solar cell 100A and the second electrode 110B of the second solar cell 100B may be bonded to each other with the conductive adhesive member 200 interposed therebetween, or the contact-resistance-reducing layer 108A of the first solar cell 100A and the second electrode 110B of the second solar cell 100B may be bonded to each other with the conductive adhesive member 200 interposed therebetween.

When the contact-resistance-reducing layer 108A is provided on a partial region or the entire surface of the conductive corrosion-preventive layer 107A opposite to the first conductive substrate 101A, the conductive corrosion-preventive layer 107A of the first solar cell 100A and the second electrode 110B of the second solar cell 100B are bonded to each other with the contact-resistance-reducing layer 108A and the conductive adhesive member 200 interposed therebetween.

By bonding the first solar cell 100A and the second solar cell 100B by the bonding step according to the present embodiment, simpler and stronger bonding between the solar cells 100 tends to be realized.

### 3.1.1. Thermocompression bonding step

The bonding step preferably includes a thermocompression bonding step of heating the first solar cell 100A, the second solar cell 100B, and the conductive adhesive member 200 at 125°C or higher for 3 minutes or longer and applying a pressure of 0.1 MPa or higher. When the bonding step includes the thermocompression bonding step, the first solar cell 100A and the second solar cell 100B tend to be more firmly bonded to each other with the conductive adhesive member 200 interposed therebetween.

A time for performing the thermocompression bonding step is preferably 3 minutes or longer, 3 minutes or longer and 60 minutes or shorter, 10 minutes or longer and 50 minutes or shorter, or 15 minutes or longer and 40 minutes or shorter.

A heating temperature in the thermocompression bonding step is preferably 125°C or higher, 125°C or higher and 200°C or lower, 130°C or higher and 180°C or lower, or 135°C or higher and 160°C or lower.

A pressure applied in the thermocompression bonding step is preferably 0.1 MPa or more, 0.1 MPa or more and 1.5 MPa or less, or 0.1 MPa or more and 1.0 MPa or less. Alternatively, the pressure applied in the thermocompression bonding step is preferably 0.3 MPa or more and 1.5 MPa or less, or 0.5 MPa or more and 1.0 MPa or less.

### 4. Method of using solar cell

In the solar module 1 according to the present embodiment, the solar cells 100 are simply and firmly connected to each other. Furthermore, by forming the solar cell 100 to be sufficiently thin, the solar module 1 can be formed to be thin, and thus the solar module 1 has flexibility. Therefore, the solar module 1 can be suitably used in various environments such as an electric vehicle, an electric aircraft, and an artificial satellite from the viewpoint of mechanical vibration and thermal shock. In addition, since the solar module 1 has a low-resistance series connection between the solar cells 100, a sufficient amount of power generation can be provided even when used in various environments as described above.

In addition, the solar module 1 according to the present embodiment can be used as an independent power supply device used for street lights, sensors, digital signage, and the like. In addition, the solar module 1 according to the present embodiment can also be used as a mobile energy device.

### EXAMPLES

The present invention will be specifically described with reference to Examples and Comparative Examples. The present invention is not limited in any way by the following examples. In addition, the experiments of Examples and Comparative Examples were conducted at room temperature (25°C) and 1 atm unless otherwise specified.

### [Example 1]

In Example 1, a titanium foil having a thickness of 50 µm was used as a conductive substrate. On the conductive substrate, CuGa and In, which are precursors of the light-absorbing layer made of the CIGSS compound, were laminated with a thickness of 2 µm by a sputtering method. On the surface of the conductive substrate opposite to the precursor of the light-absorbing layer, a conductive corrosion-preventive layer made of metallic molybdenum was formed with a thickness of 200 nm by a sputtering method. In this manner, a laminate was prepared. In each of Examples and Comparative Examples, the same precursor of the light-absorbing layer as in Example 1 was used.

The laminate having the above-described precursor was subjected to a heat treatment at 500°C for 5 minutes in a selenium atmosphere. Thereafter, the laminate having the above-described precursor was subjected to a heat treatment at 550°C for 15 minutes in a sulfur atmosphere to form a light-absorbing layer with a thickness of 2 µm.

On the light-absorbing layer of the laminate after the heat treatment, an electron transport layer which is an n-type oxide semiconductor containing titanium zinc oxide was formed with a thickness of 80 nm by a sputtering method. On the electron transport layer, an electrode layer which is a transparent electrode layer containing hydrogen-containing indium oxide (IOH) was formed with a thickness of 300 nm by a sputtering method. On the electrode layer, a grid electrode made of metallic silver was formed with a thickness of 5 µm by a vapor deposition method. In this manner, two solar cells were produced.

After bonding the conductive corrosion-preventive layer of one solar cell and the grid electrode of the other solar cell with a conductive adhesive member (double-sided conductive tape manufactured by SEIREN Co., Ltd., product name: MST50), both solar cells and the conductive adhesive member were heated at 150°C and thermocompression-bonded for 30 minutes while applying a pressure of 0.1 MPa. In this manner, a solar module of Example 1 was obtained.

### [Example 2]

A laminate was obtained in the same manner as in Example 1, and the laminate was subjected to a heat treatment in the same manner as in Example 1. An electron transport layer and an electrode were formed on the laminate after the heat treatment in the same manner as in Example 1. Next, a contact-resistance-reducing layer made of metallic silver was formed with a thickness of 100 nm on the surface of the conductive corrosion-preventive layer opposite to the conductive substrate by a sputtering method. In this manner, two solar cells were produced. After bonding the contact-resistance-reducing layer of one solar cell and the grid electrode of the other solar cell with a conductive adhesive member (double-sided conductive tape manufactured by SEIREN Co., Ltd., product name: MST50), both solar cells and the conductive adhesive member were heated at 150°C and thermocompression-bonded for 30 minutes while applying a pressure of 0.1 MPa. In this manner, a solar module of Example 2 was obtained.

### [Example 3]

A solar module of Example 3 was obtained in the same manner as in Example 1, except that a conductive corrosion-preventive layer made of a molybdenum-nickel alloy (% by mass of elemental molybdenum:% by mass of elemental nickel in the alloy = 70:30) was provided by a sputtering method instead of the conductive corrosion-preventive layer made of metallic molybdenum. Note that, in each of Examples and Comparative Examples, when a molybdenum-nickel alloy was used, a molybdenum-nickel alloy having % by mass of elemental molybdenum:% by mass of elemental nickel in the alloy of 70:30 was used.

### [Example 4]

A solar module of Example 4 was obtained in the same manner as in Example 2, except that a conductive corrosion-preventive layer made of a molybdenum-nickel alloy was provided by a sputtering method instead of the conductive corrosion-preventive layer made of metallic molybdenum.

### [Comparative Example 1]

In Comparative Example 1, a titanium foil having a thickness of 50 µm was used as a conductive substrate. On the conductive substrate, a precursor of a light-absorbing layer made of a CIGSS compound was laminated with a thickness of 2 µm by a sputtering method. In this manner, a laminate was prepared.

The laminate having the above-described precursor was subjected to a heat treatment at 500°C for 5 minutes in a selenium atmosphere. Thereafter, the laminate having the above-described precursor was subjected to a heat treatment at 550°C for 15 minutes in a sulfur atmosphere to form a light-absorbing layer with a thickness of 2 µm.

On the light-absorbing layer of the laminate after the heat treatment, an electron transport layer which is an n-type oxide semiconductor containing titanium zinc oxide was formed with a thickness of 80 nm by a sputtering method. On the electron transport layer, an electrode layer which is a transparent electrode layer containing hydrogen-containing indium oxide (IOH) was formed with a thickness of 300 nm by a sputtering method. On the electrode layer, a grid electrode made of metallic silver was formed with a thickness of 5 µm by a vapor deposition method. In this manner, two solar cells were produced.

After bonding the conductive substrate of one solar cell and the grid electrode of the other solar cell with a conductive adhesive member (double-sided conductive tape manufactured by SEIREN Co., Ltd., product name: MST50), both solar cells and the conductive adhesive member were heated at 150°C and thermocompression-bonded for 30 minutes while applying a pressure of 0.1 MPa. In this manner, a solar module of Comparative Example 1 was obtained.

### [Comparative Example 2]

A laminate was obtained in the same manner as in Comparative Example 1, and the laminate was subjected to a heat treatment in the same manner as in Comparative Example 1. An electron transport layer and an electrode layer were formed on the laminate after the heat treatment in the same manner as in Comparative Example 1. Next, a contact-resistance-reducing layer made of metallic silver was formed with a thickness of 200 nm on the surface of the conductive substrate opposite to the light-absorbing layer by a sputtering method. In this manner, two solar cells were produced. After bonding the contact-resistance-reducing layer of one solar cell and the grid electrode of the other solar cell with a conductive adhesive member (double-sided conductive tape manufactured by SEIREN Co., Ltd., product name: MST50), both solar cells and the conductive adhesive member were heated at 150°C and thermocompression-bonded for 30 minutes while applying a pressure of 0.1 MPa. In this manner, a solar module of Comparative Example 2 was obtained.

### [Example 5]

A solar module of Example 5 was obtained in the same manner as in Example 2, except that a contact-resistance-reducing layer was formed with a thickness of 200 nm by a vacuum deposition method instead of the sputtering method.

### [Example 6]

A solar module of Example 6 was obtained in the same manner as in Example 2, except that a contact-resistance-reducing layer made of a tin-zinc alloy was formed with a thickness of 5 µm by an ultrasonic soldering method instead of forming the contact-resistance-reducing layer made of metallic silver by the sputtering method.

### [Example 7]

Two solar cells were produced in the same manner as in Example 4, except that a contact-resistance-reducing layer made of a tin-zinc alloy was formed with a thickness of 5 µm by an ultrasonic soldering method instead of forming the contact-resistance-reducing layer made of metallic silver by the sputtering method.

After bonding the contact-resistance-reducing layer of one solar cell and the grid electrode of the other solar cell with a conductive adhesive member (double-sided conductive tape manufactured by SEIREN Co., Ltd., product name: MST50), both solar cells and the conductive adhesive member were heated at 75°C and thermocompression-bonded for 0.5 minutes while applying a pressure of 0.1 MPa. In this manner, a solar module of Example 7 was obtained.

### [Examples 8 to 21]

Solar modules of Examples 8 to 21 were obtained in the same manner as in Example 7, except that the temperature, time, and pressure conditions for performing the thermocompression bonding step were changed as shown in Table 3.

### [Evaluation]

### (Bonding resistance ratio to soldering)

First, a solar module for control was produced as follows.

A titanium foil having a thickness of 50 µm was used as a conductive substrate. On the conductive substrate, a precursor of a light-absorbing layer made of a CIGSS compound was laminated with a thickness of 2 µm by a sputtering method. In this manner, a laminate was prepared.

The laminate having the above-described precursor was subjected to a heat treatment at 500°C for 5 minutes in a selenium atmosphere. Thereafter, the laminate having the above-described precursor was subjected to a heat treatment at 550°C for 15 minutes in a sulfur atmosphere to form a light-absorbing layer with a thickness of 2 µm.

On the light-absorbing layer of the laminate after the heat treatment, an electron transport layer which is an n-type oxide semiconductor containing titanium zinc oxide was formed with a thickness of 80 nm by a sputtering method. On the electron transport layer, an electrode layer which is a transparent electrode layer containing hydrogen-containing indium oxide (IOH) was formed with a thickness of 300 nm by a sputtering method. On the electrode layer, a grid electrode made of metallic silver was formed with a thickness of 5 µm by a vapor deposition method. In this manner, two solar cells were produced.

The conductive substrate of one solar cell and the grid electrode of the other solar cell were ultrasonically soldered. In this manner, the solar module for control was obtained. In the solar cells constituting the solar module for control, the exposed surface of the conductive substrate is modified by the heat treatment. However, since the conductive substrate of one solar cell and the grid electrode of the other solar cell were bonded by ultrasonic soldering, the influence of the modification on the bonding resistance in the bonding region between the solar cells was absent or negligible.

Regarding the solar module for control, a bonding resistance in the bonding region between the solar cells was determined. In addition, regarding each of Examples and Comparative Examples, a bonding resistance in the bonding region between the solar cells was determined. Next, the bonding resistance of the solar module of each of Examples and Comparative Examples was divided by the bonding resistance of the solar module for control to determine a bonding resistance ratio of each of Examples and Comparative Examples.

Tables 1 to 3 show the evaluation results of each of Examples and Comparative Examples.

**[Table 1]**

| | Comparative Example 1 | Comparative Example 2 | Example 1 |
|---|---|---|---|
| Corrosion-preventive layer | None | None | Metallic molybdenum |
| Contact-resistance-reducing layer | None | Metallic silver | None |
| Bonding resistance ratio (%) | 309 | 350 | 202 |
| | Example 2 | Example 3 | Example 4 |
| Corrosion-preventive layer | Metallic molybdenum | Molybdenum-nickel alloy | Molybdenum-nickel alloy |
| Contact-resistance-reducing layer | Metallic silver | None | Metallic silver |
| Bonding resistance ratio (%) | 113 | 107 | 100 |

**[Table 2]**

| | | Example 5 | Example 6 |
|---|---|---|---|
| Corrosion-preventive layer | | Metallic molybdenum | Metallic molybdenum |
| Contact-resistance-reducing layer | Type | Metallic silver | Tin-zinc alloy |
| | Production method | Vacuum deposition | Ultrasonic soldering |
| Bonding resistance ratio (%) | | 112 | 113 |

**[Table 3]**

| | | Example 7 | Example 8 | Example 9 | Example 10 | Example 11 |
|---|---|---|---|---|---|---|
| Corrosion-preventive layer | | Molybdenum-nickel alloy | Molybdenum-nickel alloy | Molybdenum-nickel alloy | Molybdenum-nickel alloy | Molybdenum-nickel alloy |
| Contact-resistance-reducing layer | | Tin-silver alloy | Tin-silver alloy | Tin-silver alloy | Tin-silver alloy | Tin-silver alloy |
| Thermocompression bonding | Temperature (°C) | 75 | 75 | 75 | 125 | 125 |
| | Time (min) | 0.5 | 3 | 5 | 0.5 | 3 |
| | Pressure | 0.1 | 0.1 | 0.1 | 0.1 | 0.1 |
| | (MPa) | | | | | |
| Bonding resistance ratio (%) | | 232 | 166 | 138 | 223 | 122 |
| | | Example 12 | Example 13 | Example 14 | Example 15 | Example 16 |
| Corrosion-preventive layer | | Molybdenum-nickel alloy | Molybdenum-nickel alloy | Molybdenum-nickel alloy | Molybdenum-nickel alloy | Molybdenum-nickel alloy |
| Contact-resistance-reducing layer | | Tin-silver alloy | Tin-silver alloy | Tin-silver alloy | Tin-silver alloy | Tin-silver alloy |
| Thermocompression bonding | Temperature (°C) | 125 | 150 | 150 | 150 | 125 |
| | Time (min) | 5 | 0.5 | 3 | 5 | 3 |
| | Pressure (MPa) | 0.1 | 0.1 | 0.1 | 0.1 | 0.3 |
| Bonding resistance ratio (%) | | 123 | 212 | 119 | 100 | 100 |
| | | Example 17 | Example 18 | Example 19 | Example 20 | Example 21 |
| Corrosion-preventive layer | | Molybdenum-nickel alloy | Molybdenum-nickel alloy | Molybdenum-nickel alloy | Molybdenum-nickel alloy | Molybdenum-nickel alloy |
| Contact-resistance-reducing layer | | Tin-silver alloy | Tin-silver alloy | Tin-silver alloy | Tin-silver alloy | Tin-silver alloy |
| Thermocompression bonding | Temperature (°C) | 125 | 125 | 150 | 150 | 150 |
| | Time (min) | 3 | 3 | 3 | 3 | 3 |
| | Pressure (MPa) | 0.4 | 0.5 | 0.3 | 0.4 | 0.5 |
| Bonding resistance ratio (%) | | 113 | 122 | 130 | 109 | 108 |

Regarding a layer made of metallic titanium, metallic molybdenum, metallic nickel, metallic niobium, metallic chromium, metallic tungsten, carbon, silicon, and a nickel-molybdenum alloy, the coefficient of thermal expansion was measured at 20°C, 200°C, and 500°C. The results are shown in Table 4. In Table 4, the alloy represented by Mo90Ni10 represents a molybdenum-nickel alloy in which a ratio of the content of elemental molybdenum to the content of elemental nickel in the alloy (% by mass of elemental molybdenum:% by mass of elemental nickel in the alloy) was 90:10. Mo80Ni20, Mo70Ni30, Mo60Ni40, and Mo50Ni50 each represent molybdenum-nickel alloys in which the above ratios were 80:20, 70:30, 60:40, and 50:50, respectively.

The coefficient of thermal expansion of each layer was measured according to JIS Z 2285:2003, in which the temperature was set to 20°C, 200°C, or 500°C.

**[Table 4]**

| Type of layer | Titanium | Molybdenum | Nickel | Niobium | Chromium | Tungsten | Carbon |
|---|---|---|---|---|---|---|---|
| Coefficient of thermal expansion at 20°C (10⁻⁶/°C) | 8.6 | 4.9 | 13.4 | 7.1 | 4.9 | 4.5 | 3.1 |
| Coefficient of thermal expansion at 200°C (10⁻⁶/°C) | 9.9 | 5.2 | 15.3 | 7.7 | 8.8 | 4.6 | 3.3 |
| Coefficient of thermal expansion at 500°C (10⁻⁶/°C) | 11.1 | 5.7 | 16.8 | 7.9 | 11.8 | 5 | 3.6 |

| Type of layer | Silicon | Mo90Ni10 | Mo80Ni20 | Mo70Ni30 | Mo60Ni40 | Mo50Ni50 | |
|---|---|---|---|---|---|---|---|
| Coefficient of thermal expansion at 20°C (10⁻⁶/°C) | 2.6 | 5.8 | 6.6 | 7.5 | 8.3 | 9.2 | |
| Coefficient of thermal expansion at 200°C (10⁻⁶/°C) | 3.5 | 6.2 | 7.2 | 8.2 | 9.2 | 10.3 | |
| Coefficient of thermal expansion at 500°C (10⁻⁶/°C) | 4.1 | 6.8 | 7.9 | 9.0 | 10.1 | 11.3 | |

A solar module was produced in the same manner as in Example 1, except that a conductive substrate made of metallic titanium and a conductive corrosion-preventive layer made of metallic molybdenum or a molybdenum-nickel alloy shown in Table 4 were used. As a result, as the difference in the coefficient of thermal expansion between the conductive substrate and the conductive corrosion-preventive layer at 20°C, 200°C, and 500°C was smaller, the warpage of the solar cell was reduced, and as a result, the warpage of the solar module tended to be reduced.

### <Appendix>

The embodiment according to the present disclosure includes the following aspects.
[1] A solar module including:
   a first solar cell that has at least a conductive corrosion-preventive layer, a first conductive substrate, a first power generating element layer, and a first electrode in this order; and
   a second solar cell that has at least a second conductive substrate, a second power generating element layer, and a second electrode in this order,
   in which the conductive corrosion-preventive layer of the first solar cell and the second electrode of the second solar cell are bonded to each other with at least a conductive adhesive member interposed between the conductive corrosion-preventive layer and the second electrode.
[2] The solar module according to [1], in which the first solar cell further has a contact-resistance-reducing layer between the conductive corrosion-preventive layer and the conductive adhesive member.
[3] The solar module according to [2], in which the contact-resistance-reducing layer contains one or more selected from the group consisting of metallic silver, metallic tin, a silver alloy, and a tin alloy.
[4] The solar module according to any one of [1] to [3], in which a difference in coefficient of thermal expansion at 500°C between the first conductive substrate and the conductive corrosion-preventive layer is 5.0×10⁻⁶/°C or less.
[5] The solar module according to any one of [1] to [4], in which, on a surface of the conductive corrosion-preventive layer on a side facing the conductive adhesive member, at least a part of the conductive corrosion-preventive layer is sulfurized, selenized, chlorinated, brominated, or iodinated.
[6] The solar module according to any one of [1] to [5], in which the conductive corrosion-preventive layer contains metallic molybdenum or a molybdenum alloy.
[7] The solar module according to [6],
   in which the conductive corrosion-preventive layer contains a molybdenum alloy, and
   the molybdenum alloy contains one or more elements selected from the group consisting of nickel, niobium, chromium, tungsten, silicon, and carbon.
[8] The solar module according to any one of [1] to [7], in which the conductive adhesive member contains a conductive mesh fabric having a metal coating film.
[9] A solar cell including, in the following order: at least a conductive corrosion-preventive layer, a conductive substrate, a power generating element layer, and an electrode.
[10] The solar cell according to [9], further including: a contact-resistance-reducing layer on a side of the conductive corrosion-preventive layer opposite to the conductive substrate.
[11] A method for manufacturing a solar cell, the method including:
   a laminate preparation step of preparing a laminate having at least a conductive corrosion-preventive layer, a conductive substrate, and a precursor of a light-absorbing layer in this order;
   a heat treatment step of subjecting the laminate to heat treatment in one or more atmospheres selected from the group consisting of a sulfur atmosphere, a selenium atmosphere, a chlorine atmosphere, a bromine atmosphere, and an iodine atmosphere;
   a power generating element layer formation step of forming a power generating element layer having the light-absorbing layer formed by the heat treatment step; and
   an electrode formation step of forming an electrode on the power generating element layer.
[12] The manufacturing method according to [11], further including, after the heat treatment step: a contact-resistance-reducing layer formation step of forming a contact-resistance-reducing layer on the conductive corrosion-preventive layer.
[13] A method for manufacturing a solar module, the method including: a bonding step of, after obtaining a first solar cell and a second solar cell by the manufacturing method according to [11], bonding the conductive corrosion-preventive layer of the first solar cell and the electrode of the second solar cell with at least a conductive adhesive member interposed between the conductive corrosion-preventive layer and the electrode.
[14] The manufacturing method according to [13], in which the bonding step includes a thermocompression bonding step of heating the first solar cell, the second solar cell, and the conductive adhesive member at 125°C or higher for 3 minutes or longer and applying a pressure of 0.1 MPa or higher to the first solar cell, the second solar cell, and the conductive adhesive member.

### Industrial Applicability

Since the solar module of the present invention can suppress an increase in electrical resistance in a bonding region between solar cells, it has industrial applicability as a solar cell used in various environments.

### Reference Signs List

1: solar module
100: solar cell
101: conductive substrate
1011: first surface
1012: second surface
102: hole transport layer
103: light-absorbing layer
104: electron transport layer
105: electrode layer
106: grid electrode
107: conductive corrosion-preventive layer
108: contact-resistance-reducing layer
109: power generating element layer
110: electrode
200: conductive adhesive member

## Claims

1. A solar module comprising:
a first solar cell that has at least a conductive corrosion-preventive layer, a first conductive substrate, a first power generating element layer, and a first electrode in this order; and
a second solar cell that has at least a second conductive substrate, a second power generating element layer, and a second electrode in this order,
wherein the conductive corrosion-preventive layer of the first solar cell and the second electrode of the second solar cell are bonded to each other with at least a conductive adhesive member interposed between the conductive corrosion-preventive layer and the second electrode.

2. The solar module according to Claim 1, wherein the first solar cell further has a contact-resistance-reducing layer between the conductive corrosion-preventive layer and the conductive adhesive member.

3. The solar module according to Claim 2, wherein the contact-resistance-reducing layer contains one or more selected from the group consisting of metallic silver, metallic tin, a silver alloy, and a tin alloy.

4. The solar module according to Claim 1, wherein a difference in coefficient of thermal expansion at 500°C between the first conductive substrate and the conductive corrosion-preventive layer is 5.0×10⁻⁶/°C or less.

5. The solar module according to Claim 1, wherein, on a surface of the conductive corrosion-preventive layer on a side facing the conductive adhesive member, at least a part of the conductive corrosion-preventive layer is sulfurized, selenized, chlorinated, brominated, or iodinated.

6. The solar module according to Claim 1, wherein the conductive corrosion-preventive layer contains metallic molybdenum or a molybdenum alloy.

7. The solar module according to Claim 6,
wherein the conductive corrosion-preventive layer contains a molybdenum alloy, and
the molybdenum alloy contains one or more elements selected from the group consisting of nickel, niobium, chromium, tungsten, silicon, and carbon.

8. The solar module according to Claim 1, wherein the conductive adhesive member contains a conductive mesh fabric having a metal coating film.

9. A solar cell comprising, in the following order: at least a conductive corrosion-preventive layer, a conductive substrate, a power generating element layer, and an electrode.

10. The solar cell according to Claim 9, further comprising: a contact-resistance-reducing layer on a side of the conductive corrosion-preventive layer opposite to the conductive substrate.

11. A method for manufacturing a solar cell, the method comprising:
a laminate preparation step of preparing a laminate having at least a conductive corrosion-preventive layer, a conductive substrate, and a precursor of a light-absorbing layer in this order;
a heat treatment step of subjecting the laminate to heat treatment in one or more atmospheres selected from the group consisting of a sulfur atmosphere, a selenium atmosphere, a chlorine atmosphere, a bromine atmosphere, and an iodine atmosphere;
a power generating element layer formation step of forming a power generating element layer having the light-absorbing layer formed by the heat treatment step; and
an electrode formation step of forming an electrode on the power generating element layer.

12. The manufacturing method according to Claim 11, further comprising, after the heat treatment step: a contact-resistance-reducing layer formation step of forming a contact-resistance-reducing layer on the conductive corrosion-preventive layer.

13. A method for manufacturing a solar module, the method comprising: a bonding step of, after obtaining a first solar cell and a second solar cell by the manufacturing method according to Claim 11, bonding the conductive corrosion-preventive layer of the first solar cell and the electrode of the second solar cell with at least a conductive adhesive member interposed between the conductive corrosion-preventive layer and the electrode.

14. The manufacturing method according to Claim 13, wherein the bonding step includes a thermocompression bonding step of heating the first solar cell, the second solar cell, and a conductive adhesive member at 125°C or higher for 3 minutes or longer and applying a pressure of 0.1 MPa or higher to the first solar cell, the second solar cell, and the conductive adhesive member.
